# EUROPEAN PATENT APPLICATION

(11) **EP 0 703 423 A1**
(43) Date of publication of application: **27.03.1996**
(21) Application number: 95109256.8
(22) Date of filing: 14.06.1995
(51) Int. Cl.: F27B 9/14, B65G 57/30, C21D 9/00, H05K 13/00

(54) **Step elevator for transporting workpieces in a vertical direction within an oven or furnace**

(30) Priority: 23.06.1994 US 264722; 27.02.1995 US 395406
(71) Applicant: GENERAL SIGNAL CORPORATION, Stamford, Connecticut 06904 (US)
(72) Inventor: Gall, Christopher A., Pewaukee, Wisconsin 53072 (US); Doubet, David L., Watertown, Wisconsin 53094 (US); Kempowski, Steven E., Watertown, Wisconsin 53094 (US); Chandler, Robert J., Fort Atkison, Wisconsin 53538 (US)
(74) Representative: Madgwick, Paul Roland

(57) **Abstract**

An elevator assembly comprising: at least two rest members (4) vertically disposed on each side of a workpiece (6), the rest members (4) being capable of moving in the horizontal direction only; at least two lift members (3) vertically disposed on each side of a workpiece (6), the lift members being capable of moving in both the horizontal and vertical direction; a plurality of support means (5) disposed about each respective rest and lift member such that the workpiece is supported by the support means; a first actuator means (1,18) capable of moving all the rest and lift members (6,4) in a horizontal direction with regard to the workpiece; and a second actuator means (7,12) capable of moving all the lift members (31) in a vertical direction with regard to the workpiece.

## Description

The present invention relates generally to a vertical conveyor furnace or oven for thermal processing of electronic devices. The unique step elevator of the present invention is capable of vertically transporting various size workpieces (e.g., electronic circuit boards) within an oven or furnace without having any moving internal drive mechanisms being exposed to the heating chamber.

Electronic circuit manufactures have been increasingly striving to yield higher production output from the same manufacturing facilities. This need has placed a demand on suppliers of electronic production equipment to design equipment that requires less factory floor space. For thermal processing equipment, the typical method of workpiece transport through the thermal process is in a horizontal direction on a mesh conveyor belt. This requires significant factory floor space for the equipment. One way to overcome this challenge is to carry workpieces vertically up then down during processing rather than horizontally as in conventional designs. The floor space requirements for vertical transport of the workpieces is much less than that required for horizontal conveyors.

Conventional methods of vertically conveying workpieces employ an adaptation of horizontal conveyors. Dual chains or belts are driven in a vertical direction by a complicated series of sprockets, bearings, tensioners and gear motors. The belts or chains have shelves from which the workpiece is suspended during conveyance. This design and others of similar nature have inherent limitations. First, the design has many moving parts that are susceptible to mis-alignment, which lead to workpieces falling off the shelves and/or conveyor jamming. Second, the moving parts incorporate lubricants or lubricating materials which limit the maximum useful temperature range of the conveyor. Third, at elevated process temperatures, the chains or belts expand causing them to lose tension, potentially resulting in mis-alignment, workpieces dropping and conveyor jamming. Tension adjustment is impossible while at processing temperatures since the tensioners are disposed within the heating chamber. Finally, the conveyor design makes separation of multiple temperature zones difficult since the mechanism requires large openings between the zones for the conveyor chain or belt to pass. Also, the conveyor adds heat load as it passes from zone to zone.

The present invention overcomes these limitations by way of a unique step elevator design. This step elevator is capable of vertically transporting various size workpieces within an oven or furnace without contacting the actuating mechanism with the heating chamber. That is, the actuating mechanisms are all disposed outside of the heating chamber, while the workpieces are moved vertically by means of a series of oppositely disposed vertical members or beams. All of such vertical members are capable of moving in a horizontal direction so as to conform to the varying sizes of selected workpieces. This allows the step elevator to be used for various size workpieces without the need for multiple furnaces with different configuration.

The present invention has the following advantages over the conventional vertical elevator furnaces. First, there are no moving internal drive mechanisms exposed to the heating chamber, such as sprockets, chains or bearings that can mis-align and jam. The moving vertical members according to one embodiment extend through the heating chamber floor and roof where they are connected externally to the drive systems. Second, the vertical members do not have to be lubricated, therefore, the maximum operating temperature of the heating chamber is not limited by this. Third, there are no tensioning devices required for the vertical members to compensate for heat related expansion and creep. Vertical member alignment is performed outside the heating chamber. This allows adjustment as needed without the need to access the elevator inside the heating chamber. Finally, the narrow cross-section of the vertical members allow easy separation of multiple zones. And since the vertical members are essentially stationary within each zone, there is no added heat load due to the vertical members once processing temperature is achieved.

According to another embodiment of the present invention the vertical members are affixed to mounting brackets and actuating shafts which are disposed within the heating chamber and only penetrate through the side wall of the heating chamber, thereby avoiding the substantial heat loss associated with the embodiment discussed immediately above. Since this embodiment does not have slots in the roof of the heating chamber, the following advantages can be realized: (1) substantial reduction in the amount of heat which can escape from the heating chamber; (2) avoidance of the creation of non-uniform temperature zones within the heating chamber; (3) avoidance of excessive heat load to the outside environment; and (4) allows sealing the penetrations through the heat chamber to make them gas tight.

The present invention also provides many additional advantages which shall become apparent as described below.

An elevator assembly comprising: at least two rest members vertically disposed on each side of a workpiece, the rest members being capable of moving in the horizontal direction only; at least two lift members vertically disposed on each side of a workpiece, the lift members being capable of moving in both the horizontal and vertical direction; a plurality of support means disposed on the rest and lift members such that the workpiece is supported by the support means; a first actuator means capable of moving all the rest and lift members in a horizontal direction with regard to the workpiece; and a second actuator means capable of moving all the lift members in a vertical direction with regard to the workpiece.

The first actuator means preferably comprises: a first horizontal actuator means capable of moving all the rest members disposed on a first side of the workpiece in a horizontal direction with regard to the workpiece; a second horizontal actuator means capable of moving all the rest members disposed on a second side of the workpiece in a horizontal direction with regard to the workpiece; a third horizontal actuator means capable of moving all the lift members disposed on a first side of the workpiece in a horizontal direction with regard to the workpiece; and a fourth horizontal actuator means capable of moving all the lift members disposed on a second side of the workpiece in a horizontal direction with regard to the workpiece.

The second actuator means preferably comprises: a first vertical actuator means capable of moving all the lift members disposed on a first side of the workpiece in a vertical direction with regard to the workpiece; and a second vertical actuator means capable of moving all the lift members disposed on a second side of the workpiece in a vertical direction with regard to the workpiece.

It is preferred that at least three rest members and at least three lift members be disposed on each of the first and second sides of the workpiece, although any number of rest and lift members may be used to satisfy the specific needs of the pending application of the elevator.

The elevator assembly may also include: a first connecting member which joins all the rest members on the first side of the workpiece; a second connecting member which joins all the rest members on the second side of the workpiece; a third connecting member which joins all the lift members on the first side of the workpiece; and a fourth connecting member which joins all the lift members on the second side of the workpiece; whereby the respective rest and lift members on either side of the workpiece move together in unison.

The elevator assembly also comprises: a first support assembly for connecting the rest members disposed on the first side of the workpiece to the first actuator means; a second support assembly for connecting the rest members disposed on the second side of the workpiece to the second actuator means; a third support assembly for connecting the lift members disposed on the first side of the workpiece to the third actuator means; a fourth support assembly for connecting the lift members disposed on the second side of the workpiece to the fourth actuator means.

A second preferred embodiment of the present invention provides for a first actuator means which comprises: (a) a first horizontal actuator means capable of simultaneously moving all the rest members disposed on a first side of the workpiece and all the rest members disposed on a second side of the workpiece in a horizontal direction with regard to the workpiece, wherein the rest members disposed on the first side of the workpiece move in a direction opposite to the direction of the rest members disposed on the second side of the workpiece; and (b) a second horizontal actuator means capable of moving all the lift members disposed on a first side of the workpiece and all the lift members disposed on a second side of the workpiece in a horizontal direction with regard to the workpiece, wherein the lift members disposed on the first side of the workpiece move in a direction opposite to the direction of the lift members disposed on the second side of the workpiece.

This second embodiment substantially reduces the amount of heat which typically escapes from the heating chamber of the elevator assembly by eliminating the need for supporting the rest members via support structures which penetrate through the roof of the heating chamber.

Moreover, the second embodiment provides that the rest members disposed on a first side of the workpiece are connected to the first horizontal actuator means by means of at least first and second rest member actuator shafts which are perpendicularly disposed with respect to the rest members disposed on the first side of the workpiece, wherein the rest members disposed on the first side of the workpiece are movably connected to the first and second rest member shafts via a first rest member mounting means which is capable of having its horizontal position about the first and second rest member actuator shafts adjusted. The rest members disposed on a second side of the workpiece are connected to the first horizontal actuator means by means of at least third and fourth rest member actuator shafts which are perpendicularly disposed with respect to the rest members disposed on the second side of the workpiece, wherein the rest members disposed on the second side of the workpiece are movably connected to the third and fourth rest member actuator shafts via a second rest member mounting means which is capable of having its horizontal position about the third and fourth rest member actuator shafts adjusted.

It also reduces the overall cost of the elevator assembly by reducing the number of stepper motors required to provide the horizontal and vertical movement of the rest and lift members. This is accomplished by connecting the first, second, third and fourth rest member actuator shafts to a reverse-thread screw of the first horizontal actuator means such that when the stepper motor is activated the reverse-thread screw causes all the first, second, third and fourth rest member actuator shafts to move substantially simultaneously, wherein the first and second rest member actuator shafts move in a direction opposite to the direction of the third and fourth rest member actuator shafts.

A furnace assembly comprising: a heating chamber which comprises at least one heat zone; at least one heating means capable of increasing the temperature of the heating chamber; at least one elevator assembly; a charge means for introducing the workpiece into the heating chamber and onto the elevator assembly; and a discharge means for removing the workpiece from the heating chamber and the elevator assembly.

Optionally, two or more elevator assemblies may be disposed side-by-side within a single furnace assembly wherein a workpiece moves up one elevator assembly and then down the adjacent elevator assembly. The workpiece is moved from one elevator assembly to another by means of a transfer means or push rod.

A method for curing an electronic circuit board which comprises: (a) charging a circuit board into the lower end of an elevator assembly disposed within a furnace assembly; (b) raising the lift members slightly in a vertical direction together with the circuit board supported thereon; (c) retracting the rest members in a horizontal direction to clear the circuit board width; (d) move the lift members, together with the circuit board which is supported thereon, in a vertical direction to the next adjacent position of the support means disposed on the stationary means; (e) move the rest members in a horizontal direction such that its support means are underneath the edges of the circuit board; (f) lower the lift members in a vertical direction such that the circuit board is disposed only on the support means of the rest members; (g) retract the lift members from the circuit board in a horizontal direction so that the support means of the lift members clear the circuit board width; (h) drive the lift members in a vertical direction so that it is slightly below the same vertical position which it had in step (a); (i) drive the lift members in a horizontal direction such that its support means are underneath the edges of the circuit board; and (j) raise the lift members slightly in a vertical direction so that it returns to the same position which it had in step (a); whereby the circuit board is disposed on the respective support means of each of the rest and lift members.

Other and further advantages and features of the present invention will be understood by reference to the following specification in conjunction with the annexed drawings, wherein like parts have been given like numbers.
Fig. 1 is a front left-side perspective view of a pair of step elevators in accordance with the present invention;
Fig. 2 is a left-side elevational view of a step elevator disposed within an oven or furnace in accordance with the present invention;
Fig. 3 is a cross-sectional view along line 3-3 of Fig. 2;
Fig. 4A is a schematic representation of adjacent lift and rest members in the 'home' position having multiple workpieces disposed therebetween;
Fig. 4B is a schematic representation of adjacent lift and rest members wherein the lift members are raised slightly above the rest members and the rest members are retracted to clear the workpieces;
Fig. 4C is a schematic representation of adjacent lift and rest members wherein the lift members are raised to the next pin location or position, slightly above the rest members;
Fig. 4D is a schematic representation of adjacent lift and rest members wherein the rest members are returned so as to again engage the workpieces;
Fig. 4E is a schematic representation of adjacent lift and rest members wherein the lift members are lowered to slightly below the rest members and then retracted so as to disengage from the workpieces;
Fig. 4F is a schematic representation of adjacent lift and rest members wherein the lift members are lowered to slightly below the starting or 'home' position as shown in Fig. 4A;
Fig. 4G is a schematic representation of adjacent lift and rest members wherein the lift members are returned so as to again engage the workpiece and then raised slightly so as to return to its 'home' position;
Fig. 4H is a schematic representation of adjacent lift and rest members wherein the pins are retractable into the vertical beams;
Fig. 5 is a front left-side perspective view of a step elevator in accordance with another embodiment of the present invention;
Fig. 6 is a cross-sectional view across line 6-6 of Fig. 5;
Fig. 7 is a cross-sectional view across line 7-7 of Fig. 5;
Fig. 8A is a cross-sectional view across line 8A-8A of Fig. 5 depicting the rest member actuator shafts and the rest member mounting brackets;
Fig. 8B is a cross-sectional view across line 8B-8B of Fig. 5 depicting the lift member shafts and the lift member mounting brackets; and
Fig. 9 is a schematic representation of adjacent rest and lift members wherein the removable metal strips containing the workpiece shelves are secured thereto by bolting the strips to their respective rest or lift member.

A furnace or oven which is primarily capable of heat treating or curing electronic circuit boards and the like has been modified to include a unique step elevator for vertically transporting the circuit boards (i.e. workpieces) internally within the heating chamber. The heating chamber is typically a single zone chamber, although multiple zone chambers are also contemplated hereby.

The step elevator can be used in ovens for processing electronic circuit boards, components and assemblies in applications including drying, curing, sealing, solder reflow, thick film, thin film and preheating.

The step elevator can be used in furnaces for processing metal components in applications including preheating, tempering, annealing, normalizing, aluminum solution heat treating, hardening and sintering.

According to a first embodiment, the step elevator includes at least two pairs of rest members or beams and at least two pairs of lift members or beams which are positioned on opposite sides of a workpiece or workpieces. The vertical members are interspersed about the heating chamber in such a way that each lift member is disposed between adjacent rest members. The lift members which are disposed together along one side of the heating chamber are preferably joined by horizontal support brackets or beams so that they move in unison. The rest members are similarly joined. Each vertical member has pins protruding therefrom at uniform intervals for supporting the workpiece along the height of the vertical members. The lift members move both vertically and horizontally, whereas the rest members move only in the horizontal direction. Through a pre-programmed series of movements, the respective vertical members move in/out and up/down to transport the workpiece either up or down one step or pin position at a time. The vertical and horizontal movements of the respective vertical members are controlled by linear drive mechanisms located outside the heating chamber.

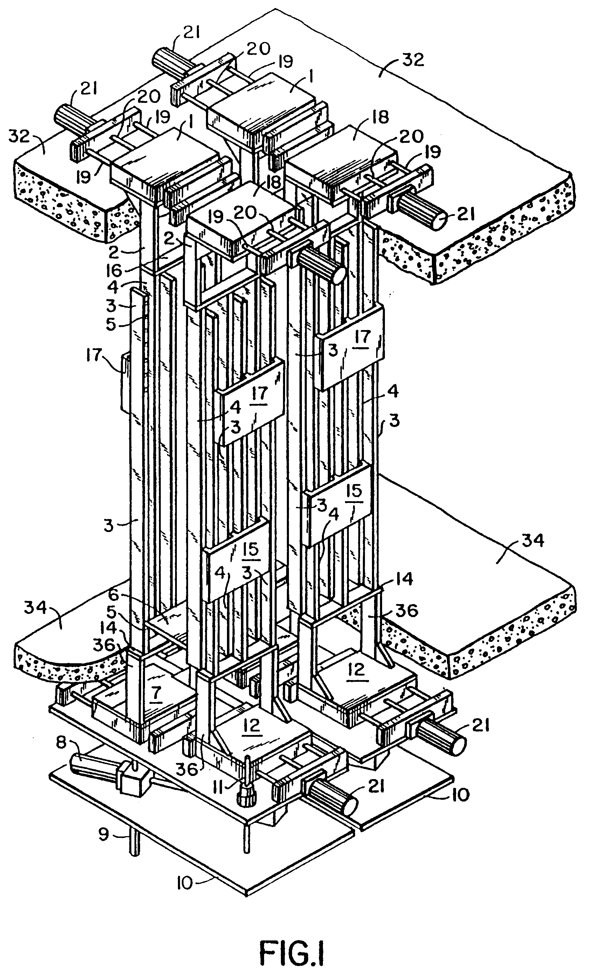

The step elevator assembly and the system for operating such an assembly within a furnace or oven according to the first embodiment can be best understood by referring to attached Figures 1-4H, wherein Fig. 1 depicts a pair of step elevators disposed within heating chamber 30 formed between a roof 32 and a floor 34 of a furnace. Each step elevator includes a number of vertical members positioned on opposite sides of workpiece 6. The vertical members comprise rest members 4 and elevator or lift members 3. Rest members 4 are equally spaced from the edge of workpiece 6 and connected together by a horizontal cross-member 15 and a horizontal top beam 16 which cause rest members 4 to move in unison. Lift members 3 are also equally spaced from the edge of workpiece 6 and connected together by a horizontal cross-member 17 and a horizontal lower beam 14 which cause lift members 3 to also move in unison. Rest members 4 and lift members 3 disposed on either side of workpiece 6 are interlaced with each other such that both sets of vertical members (3,4) are able to support workpiece 6 equally along its edges. Each rest member 4 and lift member 3 has pins 5 protruding at equally spaced intervals along the length of each respective vertical member. Workpiece 6 is disposed on these pins 5.

Rest members 4 are connected to linear drive mechanisms (1,18) that are located outside of heating chamber 30. The connection is made at the top of each set of rest members 4 by support structure 2 which is connected to horizontal top beam 16 and which extends through the roof 32 of heating chamber 30. Linear drive mechanisms (1,18) each include a linear slide 19 that is driven by a lead screw 20 and stepper motor 21. This provides horizontal movement of rest members 4.

Lift members 3 are connected to linear drive mechanisms (7,12) that are located outside of heating chamber 30. The connection is made at the bottom of each set of lift members 3 by a support structure 36 which is connected to horizontal lower beam 14 and which extends through floor 34 of heating chamber 30. Linear drive mechanisms (7,12) each include a linear slide 19 that is driven by a lead screw 20 and stepper motor 21. This provides horizontal movement of lift members 3. Linear drive mechanisms (7,12) which are disposed under floor 34 of heating chamber 30 are additionally mounted to vertically actuated lead screw 9 and stepper motor 8 to provide vertical movement to the two sets of lift means 3 disposed on opposite sides of workpiece 6.

Linear drive mechanisms (7,12) are mounted to platform 10 that has lead screw leveling adjustments 11 for aligning the sets of beams. Alignment of the vertical members (3,4) is accomplished by adjusting lead screw leveling adjustments 11.

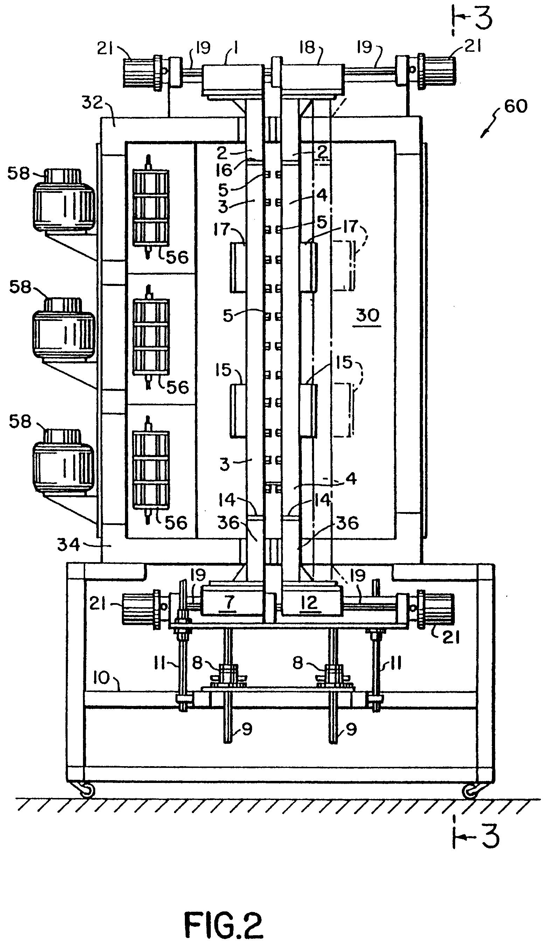

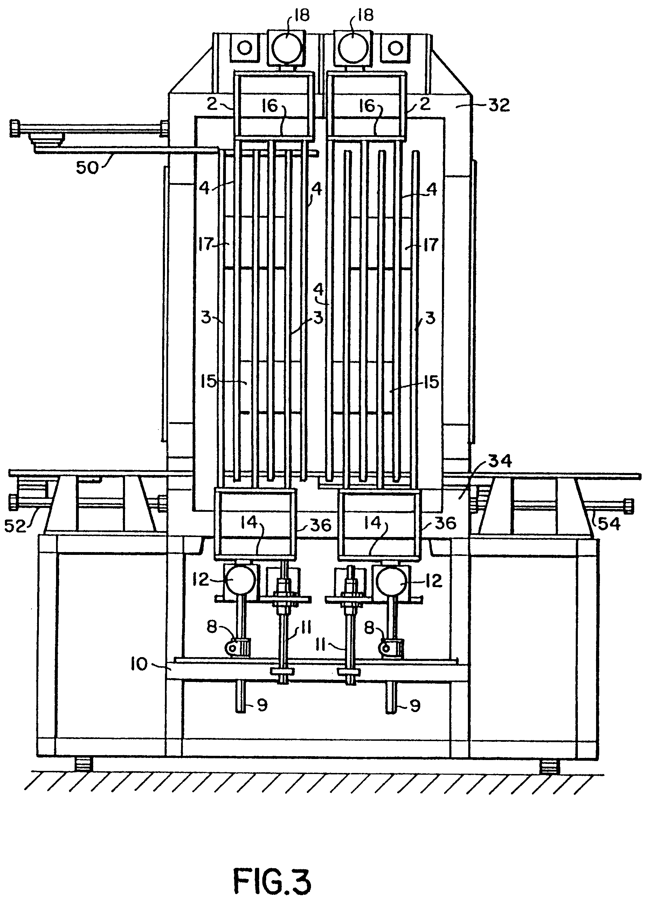

Figs. 2 and 3 depict a typical heat furnace assembly 50 which can be used to dry or cure electronic circuit boards and the like. In this application it is useful to place two step elevators side-by-side such that workpieces 6 are charged onto a first step elevator via workpiece charge mechanism 52 and then transported vertically upwards within heating chamber 30 via the first step elevator. When workpiece 6 has reached the top of the first elevator it is transferred via transfer mechanism 50 to the upper portion of a second step elevator where it is then transported vertically downwards within heating chamber 30 via this second step elevator. When workpiece 6 reaches the bottom of the second step elevator it is discharged from the second step elevator via workpiece discharge mechanism 54.

A typical electronic drying, or curing, oven or furnace includes at least one heater and blower assembly 56. Each assembly 56 is connected to a blower motor 58. Thus, the furnace 60 may have one or more heating zones, as well as various cooling zones depending upon the specific application for which furnace 60 will be used.

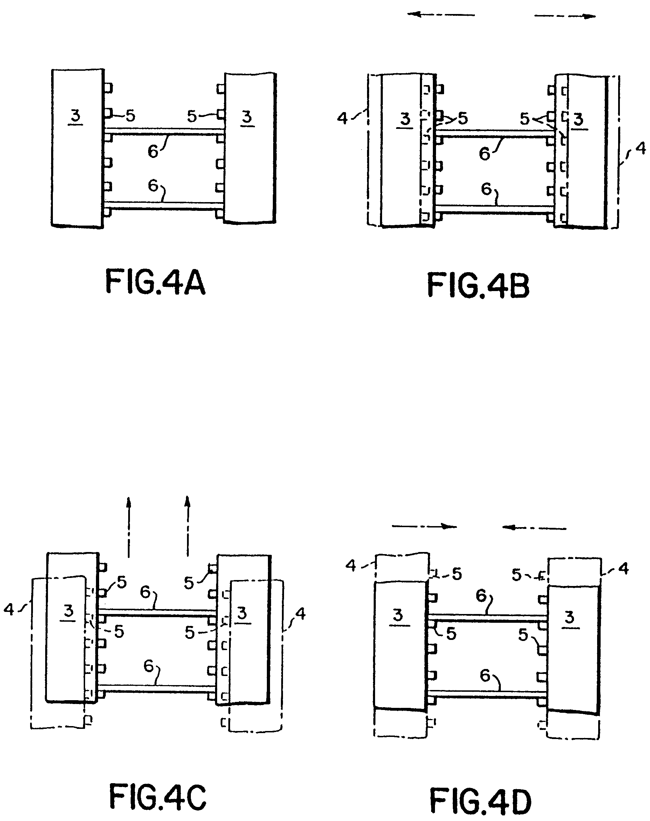

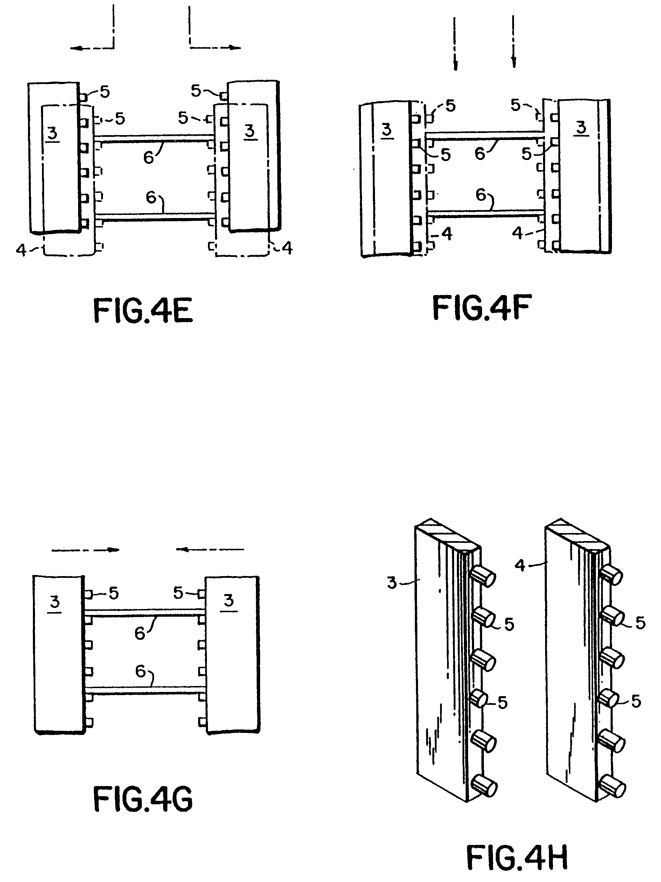

The vertical lifting of workpieces 6 from one position to the next adjacent position is demonstrated in Figs. 4A-G, wherein Fig. 4A shows workpieces 6 are disposed between a pair of lift members 3 and a pair of rest members 4. Lift members 3 are designated by the solid lines and rest members 4 are designated by the dotted lines. In Fig. 4A the lift members 3 and rest members 4 are in the starting or 'home' position wherein workpieces 6 are resting equally on pins 5 from each vertical beam (3,4).

When it is desired to move workpieces 6 vertically upward to the next position, then lift members 3 are raised slightly such that workpieces 6 are no longer resting on pins 5 protruding from rest members 4. Thereafter, rest members 4 are retracted in the horizontal direction such that pins 5 affixed to rest members 4 clear the edges of workpieces 6. This is demonstrated in Fig. 4B.

After rest members 4 have been retracted as shown in Fig. 4B, lift members 3 move vertically upwards such that workpieces 6 are raised to the next higher pin position along rest members 4. This is demonstrated in Fig. 4C. Once workpieces 6 have been raised to the next higher pin position, rest members 4 are moved back so that pins 5 affixed to rest members 4 are now underneath workpieces 6, as shown in Fig. 4D.

Thereafter, lift members 3 lower to slightly below rest members 4 such that workpieces 6 are resting on pins 5 of rest members 4. As shown in Fig. 4E, lift members 3 can now be retracted so that pins 5 affixed to lift members 3 clear workpieces 6. Once lift members 3 are fully retracted from workpieces 6 they can be lowered to slightly below their original 'home' position and moved in and slightly up to return to their 'home' position as shown in Figs. 4F and 4G.

The upward vertical transporting operation of the step elevator in one full cycle motion can best be understood while referring to Fig. 3. A workpiece 6 is charged into the lower end of the first step elevator via workpiece charge mechanism 52 and set on protruding pins 5 of vertical members (3,4). Then linear drive mechanisms (1,18) actuate to horizontally retract rest members 4 such that pins 5 disposed on rest members 4 clear the workpiece width. Vertical lead screws 9 actuate to drive lift members 3 and simultaneously workpiece 6 upward to the next level or position of pins 5 affixed to rest members 4. Then linear drive mechanisms (1,18) actuate to move rest members 4 inward such that its associated pins 5 are again underneath the edges of workpiece 6. Vertical lead screws 9 again actuate to drive lift members 3 down just far enough to set workpiece 6 on pins 5 of rest members 4. Then linear drive mechanisms (7,12) actuate to retract lift members 3 so that their associated pins 5 clear the workpiece width. Vertical lead screws 9 are again actuated to drive lift members 3 down below their original 'home' position. Linear drive mechanisms (7,12) actuate to drive lift members 3 inward such that their associated pins 5 are again underneath the edges of workpiece 6. Vertical lead screws 9 are again activated to drive light members 3 up to their original 'home' position. As such, workpiece 6 has now completed one step upward and vertical members (3,4) are in the 'home' position to repeat the cycle. This sequence of steps is repeated at specific timed intervals to transport workpiece 6 up the desired distance of the step elevator.

It is possible to load workpieces 6 on each set of pins 5 having a common plane, such that multiple workpieces 6 are moved up or down the step elevators to permit the continuous drying or curing of multiple workpieces within a pre-defined vertical space.

The step elevator can have several variations in design. There can be any number of vertical members in each set to accommodate different workpiece lengths and they can be spaced as necessary to adequately support the workpiece. The vertical members can be any length and cross-section to accommodate different workpiece heights or production rates. The vertical members can be made of different materials to accommodate different process conditions. The pins or support means that are perpendicularly affixed to vertical members can be spaced as necessary to handle different workpiece heights and these pins can be of different sizes or shapes to adequately support the workpiece. Workpieces of varying widths can also be supported by this step elevator by simply adjusting the horizontal position of each vertical member.

Typically, two step elevator assemblies are positioned next to each other so that a workpiece is transported up on one elevator and then down on the adjacent elevator, or vice-a-versa. One step elevator can be used with the workpieces changing at the bottom and discharging at the top, or vice-a-versa. More than two elevator assemblies can be positioned adjacent to one another to obtain any workpiece transport pattern desired. The vertical members are moved by linear drive mechanisms with lead screws and stepper motors. The vertical beam movements can also be accomplished with air or hydraulic cylinders.

It is also possible to provide a means for retracting pins 5 within vertical members (3,4) to avoid having to retract the vertical members in a horizontal direction so that the pins clear the workpiece width. This would result in a substantial cost saving since it would eliminate the need for linear drive mechanisms (1,18,7,12).

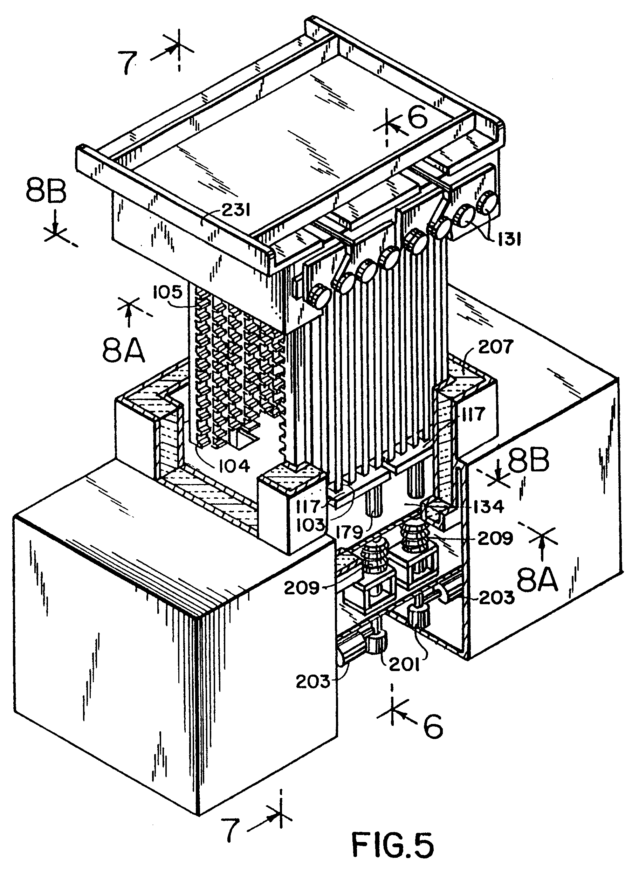

The second, but preferred, embodiment of the present invention is depicted in Figs. 5-9, wherein Fig. 5 depicts a pair of step elevators disposed within heating chamber 130 formed between a roof 132 and a floor 134 of a furnace. Each step elevator includes a number of vertical members positioned on opposite sides of workpiece 106. The vertical members comprise rest members 104 and elevator or lift members 103. Rest members 104 are equally spaced from the edge of workpiece 106 and connected together by a mounting bracket or clamp 115 which cause rest members 104 disposed on one side of workpiece 106 to move in unison. Lift members 103 are also equally spaced from the edge of workpiece 106 and connected together by a mounting bracket 117 which cause lift members 103 disposed on one side of workpiece 106 to also move in unison. Rest members 104 and lift members 103 disposed on either side of workpiece 106 are interlaced with each other such that both sets of vertical members (103,104) are able to support workpiece 106 equally along its edges. Each rest member 104 and lift member 103 has support shelves 105 protruding at equally spaced intervals along the length of each respective vertical member. Workpiece 106 is disposed on these support shelves 105.

Rest members 104 are connected to linear drive mechanism 100 which is located outside of heating chamber 130. Rest members 104 are connected to linear drive mechanism 100 by means of mounting brackets or clamps 115 to which they are affixed. Mounting brackets 115 are then movably affixed or clamped to actuator shafts 131 which provide rest members 104 with their respective horizontal movement. Shafts 131 are then connected to a bearing or linear slide 171 via a push/pull bracket 173. Linear slide 171 is then in turn connected to reverse-thread lead screw 175 via blocks 177 with threaded hole for lead screw 175 which causes rest members 104 disposed on opposite sides of workpiece 106 to move in opposite directions from one another. Reverse-thread lead screw 175 is activated by means of stepper motor 178.

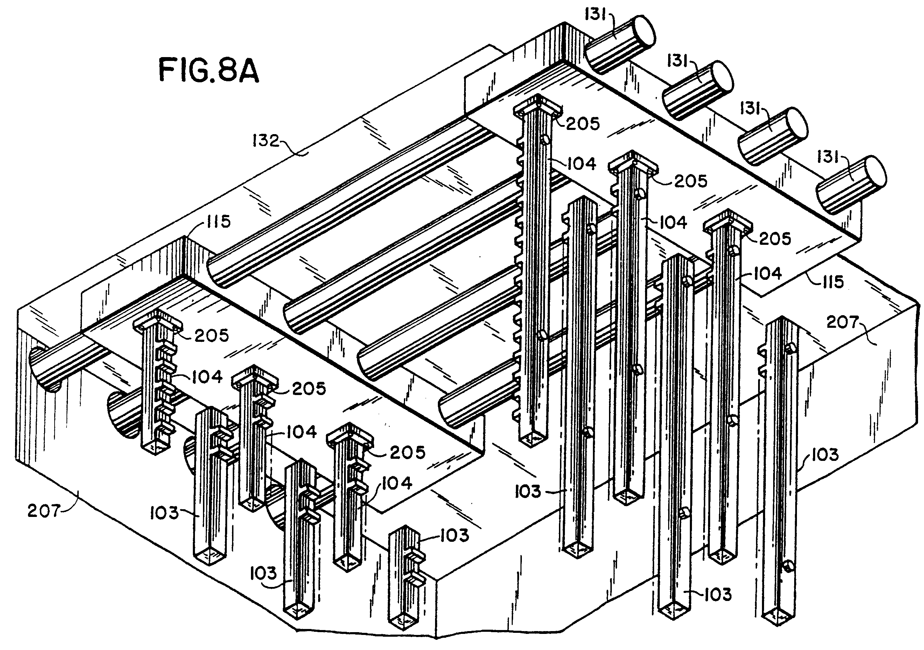

Rest members 104 disposed on a first side of workpiece 106 are connected to the first horizontal actuator means 100 by means of at least a first and second rest member actuator shafts 131 which are perpendicularly disposed with respect to rest members 104 disposed on the first side of workpiece 106, wherein rest members 104 disposed on the first side of workpiece 106 are movably connected to first and second rest member actuator shafts 131 via a first rest member mounting means 115 which is capable of having its horizontal position about first and second rest member actuator shafts 131 adjusted (see Fig. 8A). Rest members 104 disposed on a second side of workpiece 106 are connected to first horizontal actuator means 100 by means of at least third and fourth rest member actuator shafts 131 which are perpendicularly disposed with respect to rest members 104 disposed on the second side of workpiece 106, wherein rest members 104 disposed on the second side of workpiece 106 are movably connected to third and fourth rest member actuator shafts 131 via a second rest member mounting means 115 which is capable of having its horizontal position about third and fourth rest member actuator shafts 131 adjusted.

First, second, third and fourth rest member actuator shafts 131 are connected to reverse-thread screw 175 of first horizontal actuator means 100 such that when stepper motor 178 is activated reverse-thread screw 175 causes first, second, third and fourth rest member actuator shafts 131 to move substantially simultaneously, wherein first and second rest member actuator shafts 131 move in a direction opposite to the direction of third and fourth rest member actuator shafts 131.

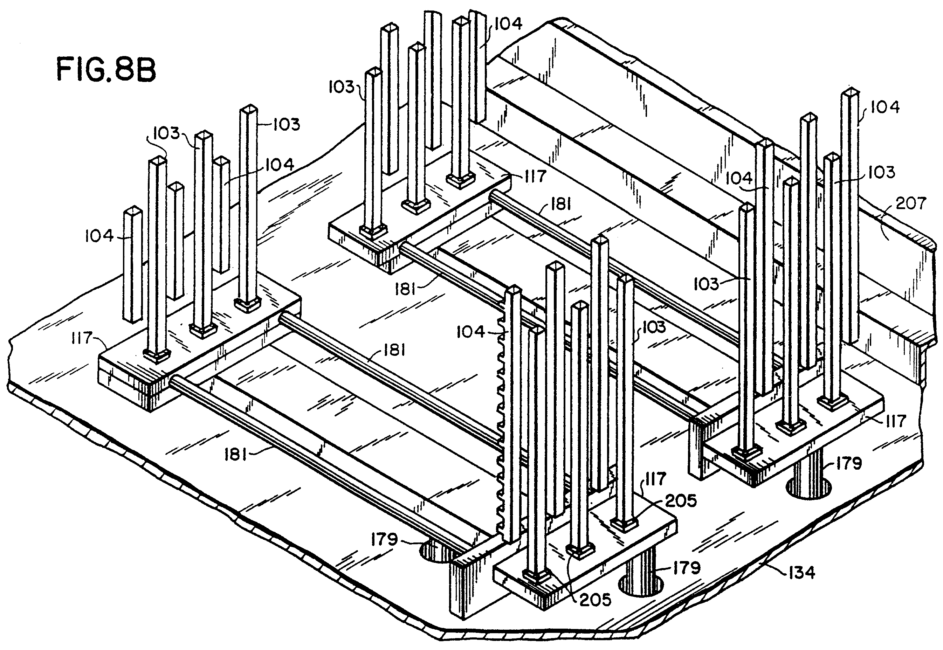

Lift members 103 are connected to linear drive mechanisms 112 that are located outside of heating chamber 130. The connection is made at the bottom of each set of lift members 103 by a mounting bracket or clamp 117 which is connected to a vertically disposed actuator shaft 179 and which extends through floor 134 of heating chamber 130 (see Fig. 8B). Mounting brackets 117 are movably affixed or clamped to non-actuating shafts 181 in order to provide for the proper spacing between oppositely disposed lift members 103 so that the elevator assembly can accommodate workpieces 106 having varying widths, e.g., 2 to 12 inches. The horizontal movement of lift members 103 is controlled by a linear drive mechanism 112 which is located outside of heating chamber 130. Lift members 103 are connected to linear drive mechanism 112 by means of mounting brackets or clamps 117 to which they are affixed. Mounting brackets 117 are affixed to actuator shafts 179 which provide lift members 103 with their respective horizontal and vertical movement. Shafts 179 are then connected to a bearing or linear slide 183 which move actuator shafts 179 in the horizontal direction. Linear slides 183 are then in turn connected to reverse-thread lead screw 185 via block 187 with threaded hole for lead screw 185 which causes lift members 103 disposed on opposite sides of workpiece 106 to move in opposite directions from one another. Reverse-thread lead screw 185 is activated by means of stepper motor 188. Actuator shafts 179 are also connected to linear screw 201 and stepper motor 203 which provide lift members 103 with their vertical movement.

Lift members 103 disposed on a first side of workpiece 106 are connected to second horizontal actuator means 112 by means of at least a first actuator shaft 179 which is disposed beneath and in substantially parallel alignment with lift members 103, wherein lift members 103 disposed on the first side of workpiece 106 are connected to first actuator shaft 179 via a first lift member mounting means 117; and lift members 103 disposed on a second side of workpiece 106 are connected to second horizontal actuator means 112 by means at least second and third actuator shafts 179 and at least first and second lift member shafts 181. First and second lift member shafts 181 are connected to second and third actuator shafts 179, respectively, and are perpendicularly disposed with respect to lift members 103 disposed on the second side of workpiece 106, wherein lift members 103 disposed on the second side of workpiece 106 are movably connected to first and second lift member shafts 181 via a second lift member mounting means 117 which is capable of having its horizontal position about first and second lift member shafts 181 adjusted.

One of the unique features of the second embodiment is that it only uses six stepper motors (178,188) versus the first embodiment which requires ten stepper motors. The reason for the reduced number of stepper motors in the second embodiment is because the horizontal movement of oppositely disposed lift and rest members (103,104) are now interconnected. For example, rest members 104 disposed on the front and rear side of an up elevator assembly are connected together by a reverse-thread lead screw 175 such that, when stepper motor 178 turns in one direction, both sets of rest members move inward and when it turns in the other direction, both sets move outward. In this way, instead of two stepper motors to control the two sets of rest members 104, only one is needed. This is also true for the rest members 104 on the down elevator assembly, as well as both lift members 103. Thus, eight stepper motors are reduced to four, and combined with the two stepper motors required for the vertical lift, the total number for the second embodiment is six stepper motors.

Lift and rest members (103,104) are according to the second embodiment tied together by a superstructure consisting of upper and lower machined platforms (231,233) that are bolted together by vertical bars 235. This provides accurate alignment of lift and rest members (103,104) and does not depend on the accuracy of fabrication of heat chamber 130.

Lift members 103 are affixed to mounting brackets or clamps 117 in such a way that each of their positions may be leveled by means of leveling or jack screws 205 disposed about each lift member 103. It is preferable that there be at least four (4) jack screws 205 disposed about each lift member 103. Rest members 104 are similarly affixed to mounting brackets 115 using jack screws 205 to provide for the leveling of each rest members 104 relevant to mounting brackets 115.

Moreover, the amount of heat and gas which can escape from the holes in floor 134 and side walls 207 due to the penetration therethrough of vertically disposed actuator shafts 179 and horizontally disposed actuator shafts 131, respectively, can be minimized by the use of flexible bellow gaskets 209 about each shaft (131,179). Bellow gaskets 209 enable the elevator assembly to remain substantially gas tight. In this way, inert gases can be used to reduce oxygen levels to low ppm count.

Each stepper motor (178,188) further comprises a means (211,213) for determining the actual position of the rest and lift members for which it is associated. Means (211,213) for determining the actual position of the rest and lift members is preferably an encoder. The encoders provide feedback of actual rest or lift member position, thereby ensuring accurate member positioning.

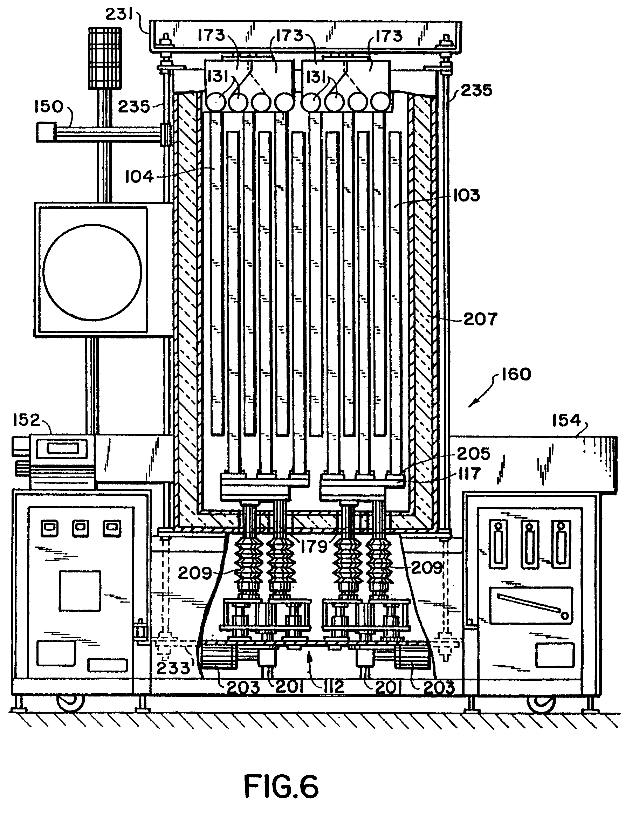

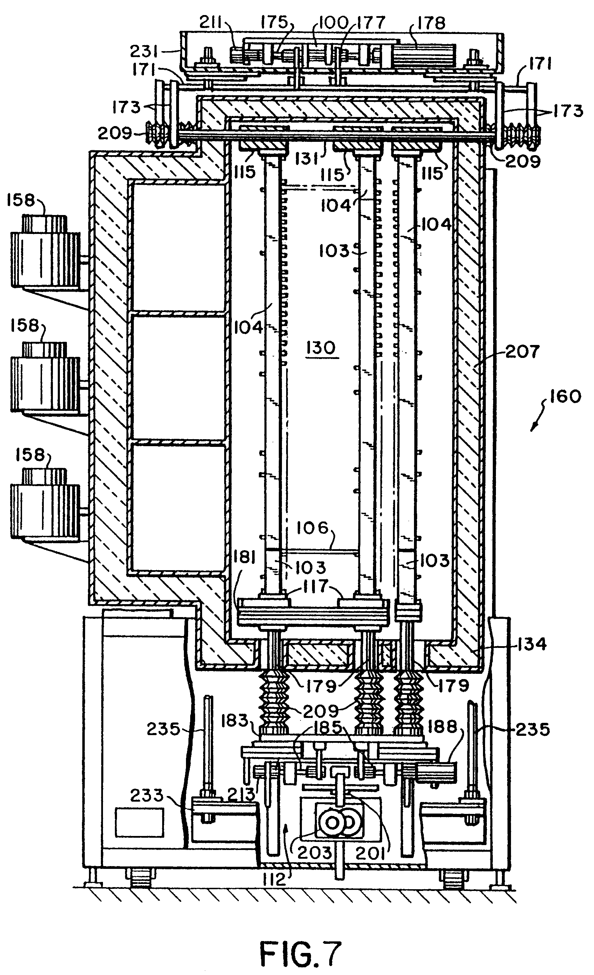

Figs. 6 and 7 depict a typical heat furnace assembly 160 which can be used to dry or cure electronic circuit boards and the like. Similar to the first embodiment, it is useful to place two step elevators side-by-side such that workpieces 106 are charged onto a first step elevator via workpiece charge mechanism 152 and then transported vertically upwards within heating chamber 130 via the first step elevator. When workpiece 106 has reached the top of the first elevator it is transferred via transfer mechanism 150 to the upper portion of a second step elevator where it is then transported vertically downwards within heating chamber 130 via this second step elevator. When workpiece 106 reaches the bottom of the second step elevator it is discharged from the second step elevator via workpiece discharge mechanism 154.

A typical electronic drying, or curing, oven or furnace includes at least one heater and blower assembly (not shown). Each heater assembly is connected to a blower motor 158. Thus, the furnace 160 may have one or more heating zones, as well as various cooling zones depending upon the specific application for which furnace 160 will be used.

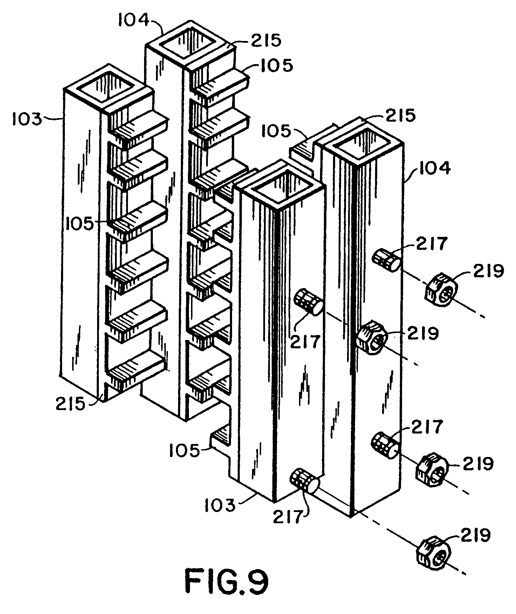

As shown in Fig. 9, a plurality of shelves 105 (i.e., a plurality of support means) are connected to a support member 215, i.e., a metal strip or flat plate. Support member 215 is replaceably mounted to a respective rest or lift member (103,104) by means of bolts 217 and nuts 219. Shelves 105 are approximately 2 inches wide and support member 215 is approximately 10 inches long. Shelves 105 offer more support along the edge of its respective workpiece than does pin 5 of the first embodiment. The novel approach of allowing for the bolting on of support members 215 allows the end user to quickly and easily replace support members 215 with other support members having different spacings between shelves 105 disposed thereon, thereby accommodating different heights of various workpieces. Thus, the change-out can be accomplished without the need to remove the lift or rest members from the heating chamber, thereby avoiding the need to re-align the lift or rest members which would be the case if new lift or rest members were installed.

While we have shown and described several embodiments in accordance with our invention, it is to be clearly understood that the same are susceptible to numerous changes apparent to one skilled in the art. Therefore, we do not wish to be limited to the details shown and described but intend to show all changes and modifications which come within the scope of the appended claims.

## Claims

1. An elevator assembly characterized by at least two rest members vertically disposed on each side of a workpiece, said rest members are capable of moving in the horizontal direction only, at least two lift members vertically disposed on each side of a workpiece, said lift members are capable of moving in both the horizontal and vertical direction, a plurality of support means disposed about each said rest and lift member such that said workpiece is supported by said support means, a first actuator means capable of moving all said rest and lift members in a horizontal direction with regard to said workpiece, and a second actuator means capable of moving all said lift members in a vertical direction with regard to said workpiece.

2. The elevator assembly according to claim 1, further characterized by a first connecting member which joins all said rest members on said first side of said workpiece, a second connecting member which joins all said rest members on said second side of said workpiece, a third connecting member which joins all said lift members on said first side of said workpiece, and a fourth connecting member which joins all said lift members on said second side of said workpiece; whereby the respective rest and lift members on either side of said workpiece move together in unison.

3. The elevator assembly according to claim 1, further characterized by a first support assembly for connecting said rest members disposed on said first side of said workpiece to said first actuator means, a second support assembly for connecting said rest members disposed on said second side of said workpiece to said second actuator means, a third support assembly for connecting said lift members disposed on said first side of said workpiece to said third actuator means, a fourth support assembly for connecting said lift members disposed on said second side of said workpiece to said fourth actuator means.

4. The elevator assembly according to claim 1, further characterized by a first platform means disposed between said third and fourth actuator means and said vertical actuator means.

5. A furnace or oven assembly characterized by a heating chamber which comprises at least one heat zone, at least one heating means capable of increasing the temperature of said heating chamber, at least one elevator assembly comprising: at least two rest members vertically disposed on each side of a workpiece, said rest members being capable of moving in the horizontal direction only; at least two lift members vertically disposed on each side of a workpiece, said lift members being capable of moving in both the horizontal and vertical direction; a plurality of support means disposed about each said rest and lift member such that said workpiece is supported by said support means; a first actuator means capable of moving all said rest and lift members in a horizontal direction with regard to said workpiece; and a second actuator means capable of moving all said lift members in a vertical direction with regard to said workpiece, a charge means for introducing said workpiece into said heating chamber and onto said elevator assembly, and a discharge means for removing said workpiece from said heating chamber and said elevator assembly.

6. The furnace assembly according to claim 5, characterized in that two elevator assemblies are disposed adjacent to each other within said furnace assembly and in that at least one transfer means is provided for transporting said workpiece from one elevator assembly to another elevator assembly.

7. The furnace assembly according to claim 5, characterized in that said first and second actuator means are disposed outside of said heating chamber.

8. The furnace assembly according to claim 5, characterized in that the elevator assembly further comprises: a first support assembly for connecting said rest members disposed on said first side of said workpiece to said first actuator means, a second support assembly for connecting said rest members disposed on said second side of said workpiece to said second actuator means, a third support assembly for connecting said lift members disposed on said first side of said workpiece to said third actuator means, and a fourth support assembly for connecting said lift members disposed on said second side of said workpiece to said fourth actuator means.

9. A method for curing or drying an electronic circuit board characterized by the steps of:
(a) charging a circuit board into the lower end of an elevator assembly disposed within a furnace or oven assembly, said elevator assembly comprising: at least two rest members vertically disposed on each side of a circuit board, said rest members being capable of moving in the horizontal direction only; at least two lift members vertically disposed on each side of a circuit board; said lift members being capable of moving in both the horizontal and vertical direction; and a plurality of support means disposed on said rest and lift members such that said circuit board is supported by one support means from each said rest and lift member disposed about said circuit board;
(b) retracting said rest members in a horizontal direction to clear said circuit board width;
(c) moving said lift members, together with said circuit board which is supported thereon, in a vertical direction to the next adjacent position of said support means disposed on said stationary means;
(d) moving said rest members in a horizontal direction such that its support means are underneath the edges of said circuit board;
(e) lowering said lift members in a vertical direction such that said circuit board is disposed only on said support means of said rest members;
(f) retracting said lift members from said circuit board in a horizontal direction so that said support means of said lift members clear the circuit board width;
(g) driving said lift members in a vertical direction so that it returns to its vertical position in step (a); and
(h) driving said lift members in a horizontal direction such that its support means are underneath the edges of said circuit board; whereby said circuit board is disposed on the respective support means of each said rest and lift member.

10. The method according to claim 9, characterized by a further step between steps (a) and (b), said further step comprising the raising of said lift members in a vertical direction so that said circuit board is no longer in contact with said support means disposed on said rest members.
